(19) Europäisches Patentamt / European Patent Office / Office européen des brevets

(11) **EP 3 975 275 B1**

(12) **EUROPEAN PATENT SPECIFICATION**

(45) Date of publication and mention of the grant of the patent:
**26.03.2025 Bulletin 2025/13**

(21) Application number: **21461507.2**

(22) Date of filing: **15.01.2021**

(51) International Patent Classification (IPC):
**H10N 99/00** (2023.01)     **H10N 50/20** (2023.01)

(52) Cooperative Patent Classification (CPC):
**H10N 99/03; H10N 50/20**

(54) **INSULATOR-BASED FIELD EFFECT TOPOLOGICAL TRANSISTOR STRUCTURE**

ISOLATORBASIERTE TOPOLOGISCHE FELDEFFEKTTRANSISTORSTRUKTUR

STRUCTURE DE TRANSISTOR TOPOLOGIQUE À EFFET DE CHAMP À BASE D'ISOLANT

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **23.09.2020 EP 20197929**

(43) Date of publication of application:
**30.03.2022 Bulletin 2022/13**

(73) Proprietor: **Instytut Fizyki Polskiej Akademii Nauk 02-668 Warszawa (PL)**

(72) Inventors:
• **Becerra, Victor Fernandez**
  **02-668 Warszawa (PL)**
• **Trif, Mircea**
  **02-668 Warszawa (PL)**
• **Hyart, Timo**
  **02-668 Warszawa (PL)**

(74) Representative: **Bury & Bury**
**Ul. Przyczolkowa 124**
**02-968 Warszawa (PL)**

(56) References cited:
**US-A1- 2012 273 763**

• **LI LIN: "Topological Insulator-Superconductor Heterostructures and Devices", 19 September 2019 (2019-09-19), XP055814256, Retrieved from the Internet <URL:https://uwspace.uwaterloo.ca/bitstream/handle/10012/15073/Li_Lin.pdf?sequence=1&isAllowed=y> [retrieved on 20210615]**
• **ABHISHEK BANERJEE ET AL: "Signatures of Topological Superconductivity in Bulk Insulating Topological Insulator BiSbTe_1.25Se_1.75 in Proximity with Superconducting NbSe_2", ARXIV.ORG, CORNELL UNIVERSITY LIBRARY, 201 OLIN LIBRARY CORNELL UNIVERSITY ITHACA, NY 14853, 17 November 2019 (2019-11-17), XP081534123, DOI: 10.1021/ACSNANO.8B07550**
• **QI I YANG ET AL: "Two-Stage Proximity-Induced Gap-Opening in Topological Insulator - Insulating Ferromagnet (Bi_xSb_1-x)_2Te_3 - EuS Bilayers", ARXIV.ORG, CORNELL UNIVERSITY LIBRARY, 201 OLIN LIBRARY CORNELL UNIVERSITY ITHACA, NY 14853, 5 April 2018 (2018-04-05), XP081226161, DOI: 10.1103/PHYSREVB.98.081403**
• **FERNÁNDEZ BECERRA V ET AL: "Topological charge, spin and heat transistor", PHYSICAL REVIEW B, 10 May 2021 (2021-05-10), XP093231875, DOI: 10.1103/PHYSREVB.103.205410**

## EP 3 975 275 B1

## Description

### Field of the invention

The present invention concerns insulator based field effect topological transistor structure and topological transistor, especially for applications in electronics, spintronics, heattronics and metrology.

### State of the art

Transistors lie at the heart of many electronic devices. They are behind the technological revolution owing to their large scalability and their ability to efficiently manipulate electrical currents and were thoroughly discussed in Adel S. Sedra and Kenneth C. Smith. Microelectronic Circuits. Oxford University Press, fifth edition, 2004.

Besides charge, the electrons carry also a spin degree of freedom which, along with the charge, can be utilised efficiently to enhance the functionalities of electronic devices. Spintronics, the field that exploits the interplay between these two degrees of freedom, emerges as an alternative to traditional electronics in the design of the next-generation nano-electronic devices discussed e.g. in Atsufumi Hirohata, Keisuke Yamada, Yoshinobu Nakatani, Ioan-Lucian Prejbeanu, Bernard Diény, Philipp Pirro, and Burkard Hillebrands. Review on spintronics: Principles and device applications. Journal of Magnetism and Magnetic Materials, 509:166711, 2020. ISSN 0304-8853. doi:https://doi.org/10.1016/j.jmmm.2020.166711. URLhttp://www.sciencedirect. com/science/article/pii/S0304885320302353. For example the giant magnetoresistance effect has opened the field of spintronics for many practical applications e.g

Albert Fert. Nobel lecture: Origin, development, and future of spintronics. Rev. Mod. Phys., 80:1517-1530, Dec 2008. doi:10.1103/RevModPhys.80.1517. URL https://link.aps.org/doi/10.1103/RevModPhys.80.1517, as well as,
Peter A. Grünberg. Nobel lecture: From spin waves to giant magnetoresistance and beyond. Rev. Mod. Phys., 80:1531-1540, Dec 2008. doi:10.1103/RevModPhys.80.1531. URL https://link.aps.org/doi/10.1103/RevMod Phys.80.1531.

Topological materials are currently some of the most scrutinised solid state systems. They are the golden standard for future spintronic devices, as the spin and charge degrees of freedom are intrinsically linked to each other in these materials. This is best exemplified in the case of quantum spin Hall insulators (QSHI), where the electrons moving right and left carry opposite spins. Although it is widely accepted that these new materials hold a technological promise, we are only at the beginning of the development of tangible and useful applications based on them. Nevertheless, from the previously explored topological phenomena, quantum Hall effect and ac Josephson effect, we know that the topological effects are well-suited for metrology applications due to the high-accuracy of quantization of physical observables and the robustness of the response so that the variations between devices are small. The quantum Hall effect has been widely used as a resistance standard (J. Weis and K. von Klitzing. Metrology and microscopic picture of the integer quantum Hall effect. Phil. Trans. R. Soc. A, 369:3954, 2011. doi:http://doi.org/10.1098/rsta.2011.0198) and ac Josephson effect as a voltage standard - Clark A. Hamilton. Josephson voltage standards. Review of Scientific Instruments, 71(10):3611-3623, 2000. doi:10.1063/1.1289507. URL https://aip.scitation.org/doi/abs/10.1063/1.1289507.

Majorana zero (energy) modes were discussed in Liang Fu and C. L. Kane. Superconducting Proximity Effect and Majorana Fermions at the Surface of a Topological Insulator. Phys. Rev. Lett., 100:096407, Mar 2008. doi:10.1103/PhysRevLett.100.096407. URL https://link.aps.org/doi/10.1103/PhysRevLett.100.096407 and Liang Fu and Charles L Kane. Josephson current and noise at a superconductor/quantum-spin-Hall-insulator/superconductor junction. Physical Review B, 79(16):161408, 2009. The technology for building this type of setups for the purpose of utilising Majorana zero modes as a staple ingredient for topological quantum computers was disclosed in:

Sean Hart, Hechen Ren, Timo Wagner, Philipp Leubner, Mathias Mühlbauer, Christoph Brüne, Hartmut Buhmann, Laurens W. Molenkamp, and Amir Yacoby. Induced superconductivity in the quantum spin Hall edge. Nature Physics, 10 (9):638-643, 2014. doi:10.1038/nphys3036. URL https://doi.org/10.1038/ nphys3036,
Vlad S. Pribiag, Arjan J. A. Beukman, Fanming Qu, Maja C. Cassidy, Christophe Charpentier, Werner Wegscheider, and Leo P. Kouwenhoven. Edge-mode superconductivity in a two-dimensional topological insulator. Nature Nanotechnology, 10(7):593-597, 2015. doi:10.1038/nnano.2015.86. URL https://doi.org/10. 1038/nnano.2015.86,
Hechen Ren, Falko Pientka, Sean Hart, Andrew T. Pierce, Michael Kosowsky, Lukas Lunczer, Raimund Schlereth, Benedikt Scharf, Ewelina M. Hankiewicz, Laurens W. Molenkamp, Bertrand I. Halperin, and Amir Yacoby. Topological superconductivity in a phase-controlled Josephson junction. Nature, 569(7754): 93-98, 2019. doi:10.1038/s41586-019-1148-9. URL https://doi.org/10.1038/ s41586-019-1148-9,
Antonio Fornieri, Alexander M. Whiticar, F. Setiawan, Elías Portolés, Asbjørn C. C. Drachmann, Anna Keselman, Sergei Gronin, Candice Thomas, Tian Wang, Ray Kallaher, Geoffrey C. Gardner, Erez Berg, Michael J. Manfra, Ady

2

Stern, Charles M. Marcus, and Fabrizio Nichele. Evidence of topological superconductivity in planar Josephson junctions. Nature, 569(7754):89-92, 2019. doi:10.1038/s41586-019-1068-8. URL https://doi.org/10.1038/s41586-019-1068-8,

Yu Liu, Saulius Vaitiekénas, Sara Martí-Sánchez, Christian Koch, Sean Hart, Zheng Cui, Thomas Kanne, Sabbir A. Khan, Rawa Tanta, Shivendra Upadhyay, Martin Espiñeira Cachaza, Charles M. Marcus, Jordi Arbiol, Kathryn A. Moler, and Peter Krogstrup. Semiconductor-ferromagnetic insulator-superconductor nanowires: Stray field and exchange field. Nano Letters, 20(1):456-462, 01 2020. doi:10.1021/acs.nanolett.9b04187. URL https://doi.org/10.1021/acs. nanolett.9b04187,

S. Vaitiekénas, Y. Liu, P. Krogstrup, and C. M. Marcus. Zero-field Topological Superconductivity in Ferromagnetic Hybrid Nanowires,

R. M. Lutchyn, E. P. A. M. Bakkers, L. P. Kouwenhoven, P. Krogstrup, C. M. Marcus, and Y. Oreg. Majorana zero modes in superconductor-semiconductor heterostructures. Nature Reviews Materials, 3:52, 2018. doi:10.1038/s41578-018-0003-1. URL https://doi.org/10.1038/s41578-018-0003-1.

Various types of spintronic devices utilizing the spin pumping are also known in the art, e.g.:

Yaroslav Tserkovnyak, Arne Brataas, and Gerrit E. W. Bauer. Enhanced Gilbert Damping in Thin Ferromagnetic Films. Phys. Rev. Lett., 88:117601, Feb 2002. doi:10.1103/PhysRevLett.88.117601. URL https: //link.aps.org/doi/10.1103/PhysRevLett.88.117601,

Arne Brataas, Yaroslav Tserkovnyak, Gerrit E. W. Bauer, and Bertrand I. Halperin. Spin battery operated by ferromagnetic resonance. Phys. Rev. B, 66:060404, Aug 2002. doi:10.1103/PhysRevB.66.060404. URL https://link. aps.org/doi/10.1103/PhysRevB.66.060404,

Yaroslav Tserkovnyak, Arne Brataas, Gerrit E. W. Bauer, and Bertrand I. Halperin. Nonlocal magnetization dynamics in ferromagnetic heterostructures. Rev. Mod. Phys., 77:1375-1421, Dec 2005. doi:10.1103/RevModPhys.77.1375. URL https://link.aps.org/doi/10.1103/RevModPhys.77.1375,

Jairo Sinova, Sergio O. Valenzuela, J. Wunderlich, C. H. Back, and T. Jungwirth. Spin Hall effects. Rev. Mod. Phys., 87:1213-1260, Oct 2015. doi: 10.1103/RevModPhys.87.1213. URL https://link.aps.org/doi/10.1103/ RevModPhys.87.1213.

These devices, however, do not operate in a quantized regime or behave like a transistor.

Majorana single-charge transistor was disclosed in R. Hützen, A. Zazunov, B. Braunecker, A. Levy Yeyati, and R. Egger. Majorana Single-Charge Transistor. Phys. Rev. Lett., 109:166403, Oct 2012. doi:10.1103/PhysRevLett.109.166403. URL https://link.aps.org/doi/10.1103/PhysRevLett.109.166403; single-electron transistors were disclosed in M. A. Kastner. The single-electron transistor. Rev. Mod. Phys., 64:849-858, Jul 1992. doi:10.1103/RevModPhys.64.849. URL https://link. aps.org/doi/10.1103/RevModPhys.64.849. These devices require isolated islands with large charging energy which can be inconvenient.

Spin Hall effect transistor is disclosed in Jörg Wunderlich, Byong-Guk Park, Andrew C. Irvine, Liviu P. Zârbo, Eva Rozkotová, Petr Nemec, Vít Novák, Jairo Sinova, and Tomás Jungwirth. Spin Hall Effect Transistor. Science, 330(6012):1801-1804, 2010. ISSN 0036-8075. doi:10.1126/science.1195816. URL https://science. sciencemag.org/content/330/6012/1801. This device does not demonstrate quantized operation regime.

Datta-Das spin transport based transistor is disclosed in S. Datta and B. Das. Appl. Phys. Lett, 56:665, 1990. It requires electrical control over the spin-orbit interaction in the material and also, there is no quantized operation regime in Datta-Das transistor.

While the properties of the edge states have been intensively explored in the context of time-independent perturbations, there are only few studies in the presence of time-dependent driving. Promising properties are offered by topological charge pumping effect in QSHIs (Farzad Mahfouzi, Branislav K. Nikolić, Son-Hsien Chen, and Ching-Ray Chang. Microwave-driven ferromagnet-topological-insulator heterostructures: The prospect for giant spin battery effect and quantized charge pump devices. Phys. Rev. B, 82:195440, Nov 2010. doi:10.1103/PhysRevB.82.195440. URL https://link.aps.org/doi/10.1103/PhysRevB.82.195440). This idea builds on the well-established field of spin pumping caused by time-dependent magnetization studied extensively in the context of spintronics (e.g. Yaroslav Tserkovnyak, Arne Brataas, and Gerrit E. W. Bauer. Enhanced Gilbert Damping in Thin Ferromagnetic Films. Phys. Rev. Lett., 88:117601, Feb 2002. doi:10.1103/PhysRevLett.88.117601. URL https://link.aps.org/doi/10.1103/PhysRevLett.88.117601, as well as: Arne Brataas, Yaroslav Tserkovnyak, Gerrit E. W. Bauer, and Bertrand I. Halperin. Spin battery operated by ferromagnetic resonance. Phys. Rev. B, 66:060404, Aug 2002. doi: 10.1103/PhysRevB.66.060404. URL https://link.aps.org/doi/10.1103/PhysRevB. 66.060404), but in QSHIs there exists a unique property that both the charge and spin pumping are quantized and related to each other. In the topological charge pumping proposal the driving of the magnetization direction of the ferromagnet, which is placed in proximity to the QSHI edge, can be achieved with microwaves by utilizing the ferromagnetic resonance (Yaroslav Tserkovnyak, Arne Brataas, Gerrit E. W. Bauer, and Bertrand I. Halperin. Nonlocal magnetization dynamics in ferromagnetic heterostructures. Rev. Mod. Phys., 77:1375-1421, Dec 2005. doi:10.1103/RevModPhys.77.1375. URL https://link.aps.org/doi/10.1103/RevModPhys.77.1375), or electrically using the spin Hall effect (Jairo Sinova, Sergio O. Valenzuela, J. Wunderlich, C. H. Back, and T. Jungwirth. Spin Hall effects. Rev. Mod. Phys., 87:1213-1260, Oct 2015. doi: 10.1103/RevModPhys.87.1213. URL https://link.aps.org/doi/10.1103/RevModPhys. 87.1213).

Devices based on topological crystalline insulators with electrically tunable gap are also known in the art (Junwei Liu, Timothy H. Hsieh, Peng Wei, Wenhui Duan, Jagadeesh Moodera, and Liang Fu. Spin-filtered edge states with an electrically tunable gap in a two-dimensional topological crystalline insulator. Nature Materials, 13(2): 178-183, 2014. doi:10.1038/nmat3828. URL https://doi.org/10.1038/nmat3828). Required voltages are however relatively high, and these devices do not pump the spin, charge and heat in quantized units.

Topological insulator-based transistors and transistor structures comprising: a topological insulator layer forming a substrate with drain area and source area, a gate dielectric layer, a gate contact separated from the substrate by the gate dielectric layer, drain contact by the drain area and source contact by the source area, are disclosed in US patent applications US20120273763A1 and US20170018625A1. Those devices offer no quantized operation regime and cannot be used for pumping spin, charge and heat in quantized units.

## Summary of the Invention

### Technical Problem

There is a need for elements demonstrating transistor properties working with relatively small voltages and having quantized operation regimes. The aim of the present invention is to fill this gap.

### Solution to Problem

An insulator based field effect topological transistor structure according to the invention comprises: a topological insulator layer forming a substrate with drain area and source area, a gate dielectric layer. A gate contact is separated from the substrate by the gate dielectric layer, drain contact by the drain area and source contact by the source area. The topological insulator layer is a quantum spin Hall insulator layer. The drain contact is connected to the said quantum spin Hall insulator layer. The transistor structure has a ferromagnetic insulator island placed in proximity of the edge of the said quantum spin Hall insulator layer and superconducting contact is placed in proximity of the edge of the said quantum spin Hall insulator layer and adjacent to the said ferromagnetic insulator layer. The structure according to the invention when exposed to to a time-dependent transverse magnetic field demonstrates transistor-like properties. The magnitudes of the charge, spin and heat currents can be controlled with the said microwave power, voltages applied to the said gate contacts, voltage applied to the said drain contact and temperature.

Advantageously, quantum spin Hall insulator material is intrinsically in the topologically nontrivial phase and the Fermi level is inside the band gap.

Advantageously, the quantum spin Hall insulator layer comprises two-dimensional quantum spin Hall insulator material, in particular a quantum well structure such as $WTe_2$.

Advantageously the quantum well structure comprises material selected from a group including InAs/GaSb or HgTe. The structure advantageously has gate contacts provided on the top and bottom and drain and source on the sides. The magnitudes of the currents can be controlled with gate contacts voltages.

Topological transistor according to the invention comprises a grounded superconducting contact and having means for applying a time-dependent transverse magnetic field to the structure.

Advantageously means for applying a time-dependent transverse magnetic field comprise a waveguide or transverse electro-magnetic (TEM) line.

Advantageously means for applying time-dependent transverse magnetic field comprises a coplanar waveguide.

Advantageously means for applying a time-dependent transverse magnetic field comprises a heavy metal excited with alternating signal.

**Advantageous effects of the Invention**

Implementation of the transistor is based on using the interplay between two antagonistic topological effects: quantized (and topologically protected) charge pumping pertaining to the magnetization dynamics on top of QSHI edges, and perfect (and topologically protected) Andreev reflection (AR) of electrons impinging on the Majorana zero modes. By changing the potential $V_g$ at the ferromagnetic insulator (FI) region or the precession angle $\theta$ it is possible to tune between the two regimes. Owing to the topological character of the structure, pumped signals are quantized to universal values and practically independent on $\theta$ (and thus the power supplied by an external microwave power supply) and $V_g$ for a wide range of values providing the possibility to establish standards for spin and heat pumping by comparing them to the pumped charge current, which can be measured more accurately. Therefore, transistor according to the invention can be considered a topological charge, spin and heat transistor and is denoted as TCSHT. Transistor structure TCSHTS according to the invention has transistor-like properties when subjected to a time-dependent transverse magnetic field. This kind of field can be generated and applied to the structure in numerous ways.

The charge, spin and heat pumping in the presence of time-dependent magnetization can be controlled in the transistor according to the invention with exponential sensitivity on the control parameters. Moreover, two perfectly quantized limits allow to build standards for the spin and heat pumping with the help of accurate measurement of the pumped electric charge. The analysis shows that the results are extremely robust against imperfections of the materials and external noises always present electrical circuits that are used to drive the magnetization dynamics and measure the output signals.

The present invention is based on a combination of QSHI, ferromagnetism, superconductivity and time-dependent control of magnetization. All the necessary technology has already been developed and is known in the art, yet the invention provides unique characteristics and a new scope of applications as discussed below.

This invention relies on the properties of the QSHI edges, which behave as one dimensional electronic channels, where electrons moving left and right carry opposite spins. These edge modes are ballistic due to the protection against elastic backscattering in the presence of time-reversal symmetry. Therefore, they are associated with low dissipation, high degree of robustness, perfect directionality, and strong interplay between the charge and spin degrees of freedom. They are an ideal material platform to be used in the next-generation of spintronics and electronics devices.

While the properties of the edge states have been intensively explored in the context of time-independent perturbations, there are only few studies in the presence of time-dependent driving. Invention exploits the topological charge pumping effect in QSHIs (Farzad Mahfouzi, Branislav K. Nikolić, Son-Hsien Chen, and Ching-Ray Chang. Microwave-driven ferromagnet-topological-insulator heterostructures: The prospect for giant spin battery effect and quantized charge pump devices. *Phys. Rev. B,* 82:195440, Nov 2010. doi:10.1103/PhysRevB.82.195440. URL https://link.aps.org/doi/10. 1103/PhysRevB.82.195440). This idea builds on the well-established field of spin pumping caused by time-dependent magnetization studied extensively in the context of spintronics (Yaroslav Tserkovnyak, Arne Brataas, and Gerrit E. W. Bauer. Enhanced Gilbert Damping in Thin Ferromagnetic Films. Phys. Rev. Lett., 88:117601, Feb 2002. doi:10.1103/PhysRevLett.88.117601. URL https://link.aps.org/doi/10. 1103/PhysRevLett.88.117601 as well as Arne Brataas, Yaroslav Tserkovnyak, Gerrit E. W. Bauer, and Bertrand I. Halperin. Spin battery operated by ferromagnetic resonance. Phys. Rev. B, 66:060404, Aug 2002. doi:10.1103/PhysRevB.66.060404. URL https://link.aps.org/doi/ 10.1103/PhysRevB.66.060404), but in QSHIs there exists a unique property that both the charge and spin pumping are quantized and related to each other. In the topological charge pumping the driving of the magnetization direction of the ferromagnet, which is placed in proximity to the QSHI edge, can be achieved with microwaves by utilizing the ferromagnetic resonance (Yaroslav Tserkovnyak, Arne Brataas, Gerrit E. W. Bauer, and Bertrand I. Halperin. Nonlocal magnetization dynamics in ferromagnetic heterostructures. Rev. Mod. Phys., 77:1375-1421, Dec 2005. doi:10.1103/RevModPhys.77.1375. URL https://link.aps.org/ doi/10.1103/RevModPhys.77.1375), or electrically using the spin Hall effect (Jairo Sinova, Sergio O. Valenzuela, J. Wunderlich, C. H. Back, and T. Jungwirth. Spin Hall effects. Rev. Mod. Phys., 87:1213-1260, Oct 2015. doi:10.1103/RevModPhys.87.1213. URL https://link.aps.org/doi/10.1103/RevMod Phys.87.1213).

**Brief Description of Drawings**

The invention is described in detail below, with reference to attached figures wherein:

**Fig. 1:**   presents a sketch of a topological transistor according to the invention.

**Fig. 2:**   presents dimensionless charge $\mathcal{Q}$ pumped over a cycle as a function of drain $V_d$ for various values of (a) $V_g$ and (b) $\theta$. Two different regimes are seen in the plots. Insets zoom in these two regimes, namely suppression and quantization regimes. The asymptotic limits of the pumped charge are also shown in the suppression (circles) and quantization (squares) regimes.

**Fig. 3:** presents plots: dimensionless charge $\mathcal{Q}$ pumped over a cycle as a function of $T$ for various values of (a) $V_g$ and (b) $\theta$.

**Fig. 4:** presents overall measurement setup with transistor structure according to an embodiment of the invention. Structure according to this embodiment of the invention is placed in a coplanar waveguide CPW connected to a microwave supply that generates ac magnetic field $h_{ac}(t)$ perpendicular to the applied external magnetic field $H_{ex}$.

**Fig. 5:** presents schematic side view of the transistor structure according to this embodiment of the invention.

**Fig. 6:** presents schematic top view of the transistor structure according to this embodiment of the invention.

**Fig. 7:** presents side view of a structure according another embodiment of the invention.

**Fig. 8:** presents schematic side view of the structure according to an embodiment of the invention with quantum spin Hall insulator realized using InAs/GaSb.

**Fig. 9:** presents schematic side view of the structure according to an embodiment of the invention with quantum spin Hall insulator realized using HgTe.

## Detailed description of embodiments

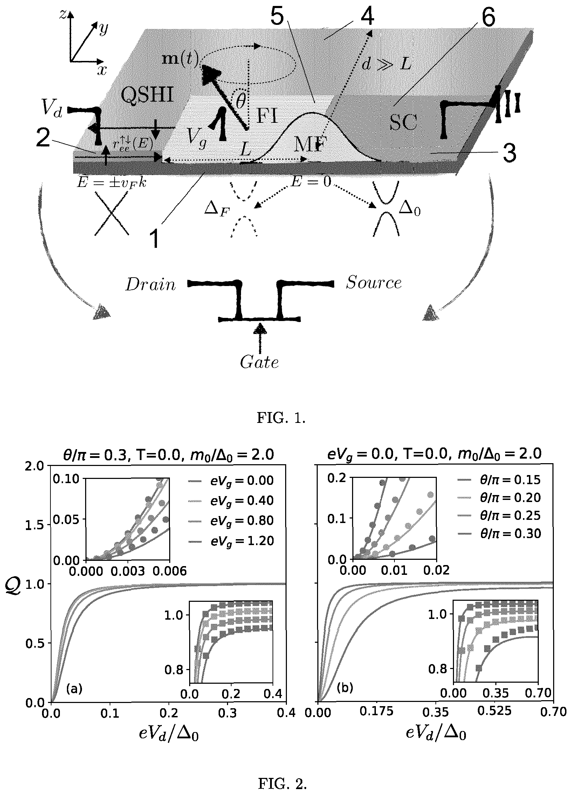

Transistor having a structure according to the invention is presented schematically in Fig. 1. It has a structure having a QSHI layer of topological insulator 4 whose gapless edges are in proximity contact with a ferromagnetic insulating island (FI) 5 and a superconducting contact (SC) 6. The FI with length L is driven by an electro-magnetic field (or by using the spin Hall effect) such that the magnetization m(t) in the monodomain precesses with respect to the z axis perpendicular to the topological insulator, driving a current to the drain (left), which can be controlled with the drain voltage $V_d$, potential $V_g$ at the FI region and the precession angle $\theta$. In the scattering matrix formalism the pumped charge, spin and heat currents are determined by the reflection amplitude $r_{ee}^{\uparrow\downarrow}$, which is strongly influenced by the Majorana fermions (MF) pinned at zero energy and localized at the FI-SC interface.

The body of the transistor is made out of a QSHI system, such as a HgTe two-dimensional (2D) quantum well. The edges of the QSHI are covered in the middle and on the right by a ferromagnetic/ferrimagnetic insulator (FI), such as Yttrium-Iron-Garnet (YIG), and an s-wave superconductor (SC), such as Aluminium, respectively, which results in the electronic spectrum being gapped in these regions (analogous to semiconductors utilised in "conventional" transistors). The drain electrode is set in the uncovered part of the edges, while the source pertains to the superconducting region. The middle part is analogous to a charge gate in a MOSFET transistor, and it also induces the current flow from the source to the drain electrodes via the magnetization dynamics. The interface between the FI and the SC harbours a localized topologically protected Majorana zero mode. The extensions of the Majorana zero mode in the ferromagnetic and superconducting region are determined by the magnitudes of the gap opened by the induced order parameters and the velocity of the edge modes. The presence of the Majorana zero mode resulting from the design of the structure causes transistor-like behaviour of the element according to the invention.

Implementation of the transistor is based on use of interplay between two antagonistic topological effects: quantized (and topologically protected) charge pumping pertaining to the magnetization dynamics on top of QSHI edges, and perfect (and topologically protected) AR of electrons impinging on the Majorana zero modes. By changing the potential $V_g$ at the FI region or the precession angle $\theta$ it is possible to tune between the two regimes. Owing to the topological character, we demonstrate that the pumped signals are quantized to universal values and practically independent on $\theta$ (and thus the power supplied by an external microwave drive) and $V_g$ for a wide range of values providing the possibility to establish standards for spin and heat pumping by comparing them to the pumped charge current, which can be measured more accurately. Therefore, transistor according to the invention can be considered a topological charge, spin and heat transistor and is denoted as TCSHT. Transistor structure TCSHTS according to the invention has transistor-like properties when exposed to time-dependent transverse magnetic field. This kind of field can be generated and applied to the structure TCSHTS in numerous ways.

The edge of a quantum spin Hall insulator (QSHI) layer is placed in proximity contact with a ferromagnetic insulating island (FI) and a grounded superconducting contact (SC). The QSHI is separated by dielectric layer from gate contacts. The ac magnetic field causes the magnetization of the FI to rotate around the axis determined by the small external magnetic field applied perpendicular to the layers. The rotating magnetization in the FI pumps charge, spin and heat to the drain contact. The magnitudes of the charge, spin and heat currents can be controlled with the microwave power, gate voltages, drain voltage and temperature.

The description below discloses: the design, the geometry, and the examples of materials required to implement the setup fo Fig. 1; quantitative theoretical description of the pumped charge, spin and heat and their dependence on the control parameters; behavior of the currents as a function of the gate voltage, magnetization precession angle, and biases applied over the structure according to embodiment of the invention; discussion of the possible scope of applications.

### A. Theoretical framework

Functionality of the transistor shown in Fig. 1 is explained below using the scattering matrix formalism. Within this framework, it was possible to extract the charge current, as well as the spin and heat currents pertaining to the magnetization precession. The general expression for the charge pumped over a precession cycle can all be written as:

$$Q_e = e\mathcal{Q}, \quad S_z = -\frac{\hbar}{2}\mathcal{Q}, \quad Q_E = \frac{\hbar\omega}{2}\mathcal{Q}, \tag{1}$$

where e is the electron charge, $\hbar$ is the Planck constant, $\omega$ is the magnetization precession frequency, and

$$\mathcal{Q} = -\frac{1}{2\pi}\int dE \left(\frac{\partial f(E)}{\partial E}\right) \int_0^{2\pi} d\phi \left|r_{\uparrow\downarrow}^{ee}(E)\right|^2, \tag{2}$$

is a dimensionless quantity that depends on the electronic distribution function $f(E)$ and the probability amplitude $r_{ee}^{\uparrow\downarrow}(E)$ for an electron with spin $\uparrow$ injected from the QSHI at energy E to be reflected back to QSHI as electron with spin $\downarrow$ because of the FI and the SC. The reflection coefficient accounts for all the possible reflection paths, including the effect of the Majorana zero mode at the FI-SC interface. In a continuous operation of the device the charges $Q_e$, $s_z$ and $Q_E$ are related to the average charge $I_e$, spin $I_s$ and heat $I_E$ currents in the drain, respectively,

$$I_e = Q_e\omega/2\pi, \quad I_s = s_z\omega/2\pi, \quad I_E = Q_E\omega/2\pi. \tag{3}$$

Therefore, all quantities of interest are determined by $\mathcal{Q}$ and in the following we discuss the dependence of Q on the various control parameters. In the following we use units where $\hbar = 1$.

### B. Quantization of the pumped charges and currents

Due to the topological effects following limiting behaviour was obtained:

$$\mathcal{Q} = \begin{cases} 0 & eV_d, k_B T \ll \Gamma, \\ 1 & eV_d, k_B T \gg \Gamma, \end{cases} \tag{4}$$

where $V_d$ is the drain potential, $\Gamma$ is the inverse lifetime of the Majorana zero mode, $k_B$ is the Boltzmann constant and $T$ is the temperature. The first (second) condition is a result of the quantization of $\mathcal{Q} = 0$ ($\mathcal{Q} = 1$) owing to the perfect topological AR by the Majorana zero mode (topological quantum pumping). Both are robust and the transitions between the two regimes as a function of $V_d$, $\Gamma$, and $T$ is exponential. That is at the core of invention functionality, and enables the possibility to utilise the device in metrology as well as a transistor.

### C. Transistor behavior of the pumped charges and currents

Here we analyze in detail the characteristics of the transistor with respect to various biases. In Fig. 2 we show the dimensionless charge $\mathcal{Q}$ as a function of $V_d$, for different values of $V_g$ and $\theta$ at $T = 0$. The insets highlight the switching behavior close to $\mathcal{Q} = 0$ and $\mathcal{Q} = 1$, respectively. The reason to show $\mathcal{Q}$ instead of the current is that it is universal and can be adapted to models based on other materials. We denote the edge velocity with $v_F$, the induced superconducting order parameter with $\Delta_0$ and the magnetic order parameter with $m_0$. The asymptotic behaviour in the inset is described by the formulas:

$$Q \approx \begin{cases} F(V_g, m_0 \sin\theta)\dfrac{e^2 V_d^2}{\Delta_0^2}\, e^{4Lm_0 \sin\theta\sqrt{1-e^2 V_g^2/m_0^2 \sin^2\theta}\big/v_F}, & eV_d \ll \Gamma \\[2em] 1 - \dfrac{\Delta_0^2}{F(V_g, m_0 \sin\theta)e^2 V_d^2}\, e^{-4Lm_0 \sin\theta\sqrt{1-e^2 V_g^2/m_0^2 \sin^2\theta}\big/v_F}, & eV_d \gg \Gamma, \end{cases} \qquad (5)$$

where

$$F(V_g, m_0 \sin\theta) = \frac{1}{4}\left(\frac{1}{1-e^2 V_g^2/m_0^2 \sin^2\theta}\right)^2 \left(1 + \frac{\Delta_0}{m_0 \sin\theta\sqrt{1-e^2 V_g^2/m_0^2 \sin^2\theta}}\right)^2, \quad (6)$$

and

$$\Gamma = \frac{\Delta_0}{\sqrt{F(V_g, m_0 \sin\theta)}}\, e^{-2Lm_0 \sin\theta\sqrt{1-e^2 V_g^2/m_0^2 \sin^2\theta}\big/v_F} \qquad (7)$$

are functions that depend only algebraically on the control parameters.

In both asymptotic regimes one notices that Q depends exponentially on $V_g$ and $\theta$. This remarkable characteristic proves robustness of the transistor according to the invention and thus its potential applications. The suppression of Q at low energies is due to the perfect AR of the electrons impinging over the Majorana mode hosted in the device. Moreover, since the perfect AR is topologically protected, this suppression occurs robustly and is not affected by disorder and other imperfections of the device. On the other hand, the quantization of Q at high energies is due to the topologically protected quantized pumping. Therefore, this result is also robust against imperfections.

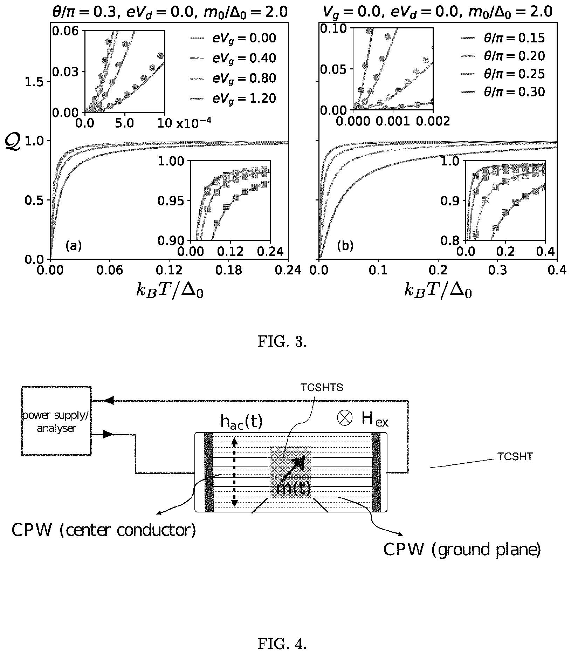

In Fig. 3, Q is plotted as a function of $T$ for different values of $V_g$ and $\theta$ assuming that $V_d = 0$. The asymptotic expressions of Q at low and high temperatures also reveal exponential dependence on $V_g$ and $\theta$

$$Q \approx \begin{cases} \dfrac{\pi^2}{3}\dfrac{k_B^2 T^2}{\Delta_0^2} F(V_g, m_0 \sin\theta)\, e^{4Lm_0 \sin\theta\sqrt{1-e^2 V_g^2/m_0^2 \sin^2\theta}\big/v_F} & k_B T \ll \Gamma, \\[2em] 1 - \dfrac{\pi}{4}\dfrac{\Delta_0}{k_B T}\dfrac{e^{-2Lm_0 \sin\theta\sqrt{1-V_g^2/m_0^2 \sin^2\theta}\big/v_F}}{\sqrt{F(V_g, m_0 \sin\theta)}} & k_B T \gg \Gamma. \end{cases} \qquad (8)$$

The calculations are performed using both a low-energy, continuum model that allows us to extract the features of the transistor behavior, and a full lattice model using a 2D implementation in (according to Christoph W Groth, Michael Wimmer, Anton R Akhmerov, and Xavier Waintal. Kwant: a software package for quantum transport. New Journal of Physics, 16(6):063065, jun 2014. doi:10.1088/1367-2630/16/6/063065) the quantum transport setup in Fig. 1. The results from the two methods are in excellent agreement, solidifying the universality and robustness of the topological transistor.

D. Variations of implementations

There are numerous variations and embodiments of the transistor structure and transistor according to the present invention. One embodiment is described in details with reference to Fig. 4, Fig. 5 and Fig. 6.

In present embodiment the time-dependent magnetic field $h_{ac}(t)$ is provided via coplanar waveguide CPW as schematically shown in Fig. 4. Structure according to the embodiment of the invention is placed falt on coplanar waveguide line CPW across center conductor and two ground planes. Coplanar waveguide CPW is connected to microwave power supply that generates an ac magnetic field perpendicular to the applied external magnetic field. Use of microwave analyser as the source of power enables better control over the field. Naturally other kinds of microwave waveguides or TEM lines can be used to apply the time dependent magetic field $h_{ac}(t)$.

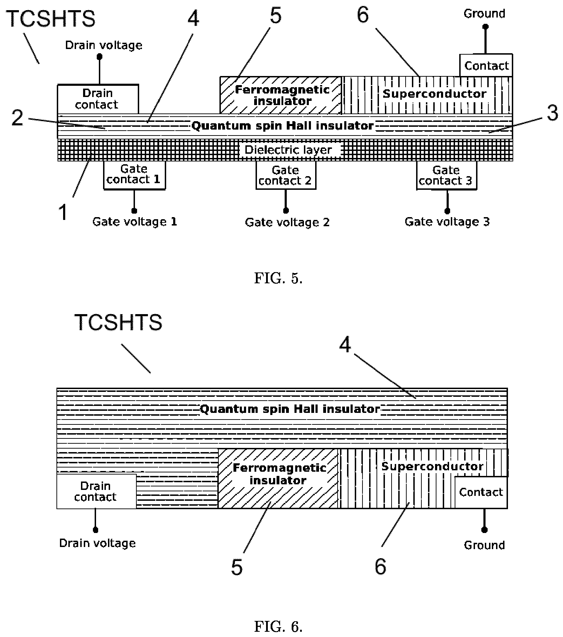

The static external magnetic field $H_{ex}$ is applied perpendicular to the transistor structure. $H_{ex}$ can be generated by using a permanent magnet or an electromagnet. It is possible to obtain magnetization dynamics without static magnetic

field $H_{ex}$ but its presence make it easier as magnetic field $H_{ex}$ controls the resonance frequency of the magnetization dynamics. The transistor structure as shown in Fig. 5 has dielectric layer forming gate dielectric layer 1 and an adjacent topological insulator layer 4 with drain area 2 and source area 3. Atop topological insulator layer 4 a ferromagnetic insulator island 5 is located. Next to topological insulator layer 4 a grounded superconducting contact 6 is provided. Below gate dielectric layer 1 gate contacts are provided while drain contact is provided over drain area 2.

As the transistor structure is placed inside the said coplanar waveguide microwave supply causes the magnetization of the said ferromagnetic insulating island to rotate around the axis determined by the said external magnetic field. This causes pumping of charge, spin and heat into the drain contact. The magnitudes of the charge, spin and heat currents can be controlled with the said microwave power, voltages applied to the said gate contacts, voltage applied to the said drain contact and temperature. The said gate contacts and the dielectric layer are not necessary for the operation of TCSHT if the quantum spin Hall insulator material is intrinsically in the topologically nontrivial phase and the Fermi level is inside the band gap. However, even in such case the magnitudes of the currents can be controlled with gate voltages applied to different gate contacts.

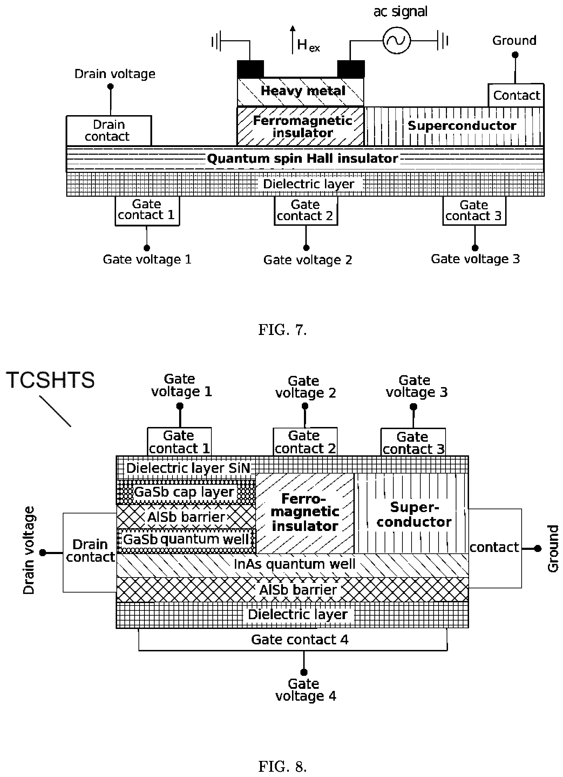

Alternatively magnetization dynamics is driven by utilizing the spin Hall effect instead of placing the structure on coplanar waveguide or other line guiding electromagnetic wave. It is possible e.g with a heavy metal with strong spin-orbit interaction being placed on the top of the ferromagnetic insulator island 5 and the external magnetic field is applied perpendicular to the layers (see Fig. 7). By applying ac voltage one drives an ac current through the heavy metal. This leads to injection of an ac spin current to the ferromagnetic insulator. This spin current generates an ac torque that drives magnetization dynamics in a similar way as the ac magnetic field in the previous embodiment shown in Fig. 4. This approach is better for scalability, because the magnetization dynamics can be driven locally in each ferromagnetic island in a more complicated circuit consisting of many TSCHTs. The heavy metal can comprise platinum (Pt) thin film, with a spin Hall angle of $\alpha_{SH} \approx 0.44$ at $T \sim 5$ K. Alternatively the heavy metal can comprise tantalum (Ta) thin film, with a spin Hall angle of $\alpha_{SH} \approx -0.4$ at $T \sim 10$ K.

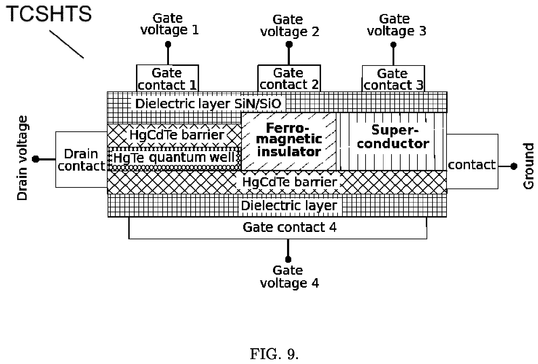

Other arrangements causing controllable magnetization of ferromagnetic insulating island may be applicable too. The TCSHT can have the quantum spin Hall insulator which is a compound selected from two-dimensional quantum spin Hall insulator materials, such as $WTe_2$. Quantum spin Hall insulator can be a quantum well structure, such as InAs/GaSb or HgTe quantum well (see Fig. 8 and Fig. 9). Instead of having gates only on one side of the sample we have included both top and bottom gates. This way it is possible to control the density of electrons and the topological properties of the quantum well structure with the gate voltages. Otherwise the design of the device is similar as of previous embodiment discussed with reference to Fig. 5 and Fig. 6.

The heterostructure shown in Fig. 8 is based on experimentally demonstrated quantum spin Hall effect in such kind of system. More technically, the quantum wells are made out of InAs and GaSb because in such kind of system it is possible to achieve band inversion of the valence and conduction bands at the $\Gamma$ point by tuning the gate voltages. Due to this band inversion the quantum spin Hall effect can appear in this system. Thus, from the physics viewpoint these quantum wells are the most important part of the heterostructure. The barriers AlSb are needed to confine the electrons to the quantum wells. The barrier, dielectric and cap layer materials are chosen this way because it has been experimentally found that high-quality/high-mobility samples can be created this way.

Also the heterostructure shown in Fig. 9 is based on experimentally demonstrated quantum spin Hall effect in such kind of system.

The important difference to Fig. 8 is that now there is only one quantum well HgTe.

The band inversion of the valence and conduction bands at the $\Gamma$ point is achieved assuming that the thickness of this quantum well is larger than approximately 6 nm. The barrier, dielectric and cap layer materials are chosen this way because it has been experimentally found that high-quality/high-mobility samples have been created this way.

The ferromagnetic insulator can be made out of a substance comprising yttrium-iron-garnet (YIG) with chemical composition $Y_3Fe_2(FeO_4)_3$, and which is a ferromagnetic material with a Curie temperature of $T_C = 560$ K. The ferromagnetic insulator can be made out of europium sulfide (Eu S), which is the inorganic compound with a Curie temperature of $T_C = 16.6$ K. Superconductor can be made made out of a substance comprising aluminium thin films (Al) with a critical temperature of $T_C \sim 1.5$ K.

Alternatively the superconductor is made out of titanium-niobium-titanium (Ti/Nb/Ti, e.g in the proportions 3 nm/80 nm/ 5 nm) trilayer structure, with a critical temperature of $T_c \sim 10$ K. The dielectrics can be made out of silicon dioxide, silicon nitride. Vacuum would also work well.

**Industrial applicability**

The TCSHT utilises a novel physical mechanism, the interplay of topological pumping and topologically protected perfect Andreev reflection, to produce robust transistor behaviour for charge, spin and heat transport.

TCSHT has two main applications. (i) Metrology for charge, spin and heat transport due to a novel physical mechanism (rooted in topology) that gives rise to a quantized pumping of charge, spin and heat in specific operation regimes and a direct correspondence between charge, spin and heat currents. (ii) Transistor-like circuit element in electronics, spintronics and heattronics that utilises a novel physical mechanism (rooted in topology) which makes it intrinsically more resistant to errors. Importantly, TCSHT can be used to pump charge, spin and heat in quantized units. The possibility to control the operation regime suggests that it could be utilised as a building block in various types of sensors and detectors.

An important difference to many other proposed devices is that the charge, spin and heat can be pumped in quantized units. In this sense, transistor according to the invention resembles single-electron transistors but it does not require small isolated islands having reasonably large charging energies.

Another important difference to many other proposed devices is that TCSHT operates on charge, spin and thermal transport, whereas most transistors and metrology standards only operate on charge current.

An important difference to various types of spintronic devices utilizing the spin pumping is that the existing devices do not have a quantized or transistor-like operation regimes. The transistor circuits according to the invention are scalable, as it is possible to pattern 2D QSHI with FI and SC arrays by various depositions methods. Our description of the operation of the device assumes that $\hbar\omega << \Delta_0$. For typical superconducting gap this means that the device can operate at microwave and gigahertz frequencies. Similar condition applies to a usual semiconductors-based transistor, where biases are smaller than the gaps in order to be able to achieve a reliable and high switch on/off ratio for the currents.

Transistor according to the present invention can be applied as transistor-like circuit element in electronics, spintronics and heattronics, but the accurate quantization of physical observables, robustness against imperfections and direct correspondence between spin, heat and charge pumping makes it possible to utilise it also in metrology as standards for spin and heat transport. Moreover, in the transistor according to the invention pumps charge, spin and heat in quantized units. The possibility to control the operation regime suggests that it could be utilised as a building block in various types of sensors and detectors.

Transistors known in the art do not anticipate transistor according to the present invention. There is a number of important differences that contribute to inventive step. State of the art standard transistors were discussed widely in: Adel S. Sedra and Kenneth C. Smith. Microelectronic Circuits. Oxford University Press, fifth edition, 2004. State of the art transistors generally only operate on electrical currents and the response is not quantized in any operation regime.

There is a significant advantage to the resistance standard based on quantum Hall effect (J. Weis and K. von Klitzing. Metrology and microscopic picture of the integer quantum Hall effect. Phil. Trans. R. Soc. A, 369:3954, 2011. doi: http://doi.org/10.1098/rsta.2011.0198) because transistor according to the present invention provides a standard for spin and heat transport whereas quantum Hall effect can be utilized as a standard for charge transport.

In addition to the totally new type of applications in the metrology for spin and heat transport, or as various types of sensors and detectors, the device can also be useful for improving the properties of the existing devices. Spin valve transistors (SVT) and magnetic tunneling transistors (MTT) are inventions able to generate and control spin currents see:

Rie Sato and Koichi Mizushima. Spin valve transistor. URL https://patentimages. storage.googleapis.com/aa/3d/50/0de7d2784d3cc4/US6833598.pdf. U.S. Patent 2003/0122208 A1, (2003)

Janusz J. Nowak, Brian W. Karr, David H. Olson, Eric S. Linville, and Paul E. Anderson. Spin transistor with ultra-low energy base-collector barrier. URL https: //patentimages.storage.googleapis.com/df/06/20/bb4f424060ebbc/US7453084. pdf. U.S. Patent 7,453,084 B2, (2008)

However, the collector-emitter current ratio is still considerably low for industrial applications ($\sim 10^{-3}$). The limitations on these type of transistors stem mainly from the two barriers present at the base-emitter and base-collector interfaces. The transistor according to the invention is able to create and control besides electrical currents and heat flow, also spin currents. However, it uses a completely different mechanism that does not face the same problems that SVTs and MTTs does.

As discussed above invention concerns entirely new type of topological transistor. The main feature of this device is the ability to manipulate the current/signal passing through the transistor with exponential sensitivity on the control parameters. A voltage (or spin; heat) bias is applied between a source and the drain, which induces a flow of carriers. That is to be modulated fast and robustly by a local gate applied on the device, which in turn allows to implement logical gates or amplify signals. The scope of the applications of transistors has exploded over the time and they are considered to be one of the greatest inventions in the 20th century. Potential scope of applications covers devices where similar kind of control exists also for the spin and heat currents, and these currents can be accurately measured and standardized with the help of charge currents. This is exactly what invention achieves.

Description above disclosed topological charge, spin and heat transistor, utilises the interplay between two topological effects, topological pumping and topologically protected perfect Andreev reflection (AR), to produce highly controllable and robust transistor behavior in solid state systems. It is based on a novel combination of building blocks, which have been recently developed in various labs around the world. The device has potential scope of applications as transistor-like circuit element in electronics, spintronics and heattronics, but the accurate quantization of physical observables, robustness against imperfections and direct correspondence between spin, heat and charge pumping makes it possible to utilise it also in metrology as standards for spin and heat transport. The possibility to control the operation regime suggests that it could be utilised as a building block in various types of sensors and detectors.

**Citation List**

**Patent Literature**

US20120273763A1, US20170018625A1

**Non-patent literature**

Abishek Banerjee et al. Signatures of Topological Superconductivity in Bulk Insulating Topological Insulator BiSbTe1.25Se1.75 in Proximity with Superconducting NbSe2. arXiv:1911.07208v1 [cond-mat.mes-hall], 2019.

Arne Brataas, Yaroslav Tserkovnyak, Gerrit E. W. Bauer, and Bertrand I. Halperin. Spin battery operated by ferromagnetic resonance. Phys. Rev. B, 66:060404, Aug 2002. doi:10.1103/PhysRevB.66.060404. URL https://link.aps. org/doi/10. 1103/PhysRevB.66.060404.

S. Datta and B. Das. Appl. Phys. Lett, 56:665, 1990.

Albert Fert. Nobel lecture: Origin, development, and future of spintronics. Rev. Mod. Phys., 80:1517-1530, Dec 2008. doi:10.1103/RevModPhys.80.1517. URL https: //link.aps.org/doi/10.1103/RevModPhys.80.1517.

Antonio Fornieri, Alexander M. Whiticar, F. Setiawan, Elias Portolés, Asbjørn C. C. Drachmann, Anna Keselman, Sergei Gronin, Candice Thomas, Tian Wang, Ray Kallaher, Geoffrey C. Gardner, Erez Berg, Michael J. Manfra, Ady Stern, Charles M. Marcus, and Fabrizio Nichele. Evidence of topological superconductivity in planar Josephson junctions. Nature, 569(7754):89-92, 2019. doi:10.1038/s41586-019-1068-8. URL https://doi.org/10.1038/s41586-019-1068-8.

Liang Fu and C. L. Kane. Superconducting Proximity Effect and Majorana Fermions at the Surface of a Topological Insulator. Phys. Rev. Lett., 100:096407, Mar 2008. doi:10.1103/PhysRevLett.100.096407. URL https:// link.aps.org/doi/10.1103/ PhysRevLett.100.096407.

Liang Fu and Charles L Kane. Josephson current and noise at a superconductor/quantum-spin-Hall-insulator/superconductor junction. Physical Review B, 79(16):161408, 2009.

Christoph W Groth, Michael Wimmer, Anton R Akhmerov, and Xavier Waintal. Kwant: a software package for quantum transport. New Journal of Physics, 16(6): 063065, jun 2014. doi:10.1088/1367-2630/16/6/063065.

Peter A. Grünberg. Nobel lecture: From spin waves to giant magnetism and beyond. Rev. Mod. Phys., 80:1531-1540, Dec 2008. doi:10.1103/RevModPhys.80.1531. URL https://link.aps.org/doi/10.1103/RevMod Phys.80.1531.

Clark A. Hamilton. Josephson voltage standards. Review of Scientific Instruments, 71 (10):3611-3623, 2000. doi:10.1063/1.1289507. URL https://aip.scitation.org/ doi/abs/10.1063/1.1289507.

Sean Hart, Hechen Ren, Timo Wagner, Philipp Leubner, Mathias Mühlbauer, Christoph Brüne, Hartmut Buhmann, Laurens W. Molenkamp, and Amir Yacoby. Induced superconductivity in the quantum spin Hall edge. Nature Physics, 10(9):638-643, 2014. doi:10.1038/nphys3036. URL https://doi.org/10.1038/nphys3036.

Atsufumi Hirohata, Keisuke Yamada, Yoshinobu Nakatani, Ioan-Lucian Prejbeanu, Bernard Diény, Philipp Pirro, and Burkard Hillebrands. Review on spintronics: Principles and device applications. Journal of Magnetism and Magnetic Materials, 509:166711, 2020. ISSN 0304-8853. doi: https://doi.org/10.1016/j.jmmm.2020.166711. URL http://www.scien cedirect. com/science/article/pii/S0304885320302353.

R. Hützen, A. Zazunov, B. Braunecker, A. Levy Yeyati, and R. Egger. Majorana Single-Charge Transistor. Phys. Rev. Lett., 109:166403, Oct 2012. doi: 10.1103/PhysRevLett.109.166403. URL https://link.aps.org/doi/10.1103/ PhysRevLett.109.166403.

M. A. Kastner. The single-electron transistor. Rev. Mod. Phys., 64:849-858, Jul 1992. doi:10.1103/RevModPhys.64.849. URL https://link.aps.org/doi/10. 1103/RevModPhys.64.849.

Lin Li. Topological Insulator-Superconductor Heterostructures and Devices. Doctoral Thesis, University of Waterloo, Ontario, Canada, 2019. URL : https://uwspace.uwaterloo.ca/bitstream/ handle/10012/15073/Li_Lin.pdf?sequence=1&isAllowed=y .

Qi I. Yang et al. Two-Stage Proximity-Induced Gap-Opening in Topological Insulator-Insulating Ferromagnet (BixSb1-x)2Te3-EuS Bilayers, arXiv:1804.02061v1 [cond-mat.mtrl-sci], 2018.

Junwei Liu, Timothy H. Hsieh, Peng Wei, Wenhui Duan, Jagadeesh Moodera, and Liang Fu. Spin-filtered edge states with an electrically tunable gap in a two-dimensional topological crystalline insulator. Nature Materials, 13(2):178-183, 2014. doi:10.1038/nmat3828. URL https ://doi.org/10.1038/nmat3828.

Yu Liu, Saulius Vaitiekėnas, Sara Martí-Sánchez, Christian Koch, Sean Hart, Zheng Cui, Thomas Kanne, Sabbir A. Khan, Rawa Tanta, Shivendra Upadhyay, Martin Espiñeira Cachaza, Charles M. Marcus, Jordi Arbiol, Kathryn A. Moler, and Peter Krogstrup. Semiconductor-ferromagnetic insulator-superconductor nanowires: Stray field and exchange field. *Nano Letters,* 20(1):456-462, 01 2020. doi: 10.1021jacs.nanolett.9b04187. URL https://doi.org/10.1021/acs.nanolett. 9b04187.

R. M. Lutchyn, E. P. A. M. Bakkers, L. P. Kouwenhoven, P. Krogstrup, C. M. Marcus, and Y. Oreg. Majorana zero modes in superconductor-semiconductor heterostructures. Nature Reviews Materials, 3:52, 2018. doi:10.1038/s41578-018-0003-1. URL https://doi.org/10.1038/s41578-018-0003-1.

Farzad Mahfouzi, Branislav K. Nikolić, Son-Hsien Chen, and Ching-Ray Chang. Microwave-driven ferromagnet-topological-insulator heterostructures: The prospect for giant spin battery effect and quantized charge pump devices. *Phys. Rev. B,* 82: 195440, Nov 2010. doi:10.1103/PhysRevB.82.195440. URL https://link.aps.org/ doi/10.1103/Phys-RevB.82.195440.

Janusz J. Nowak, Brian W. Karr, David H. Olson, Eric S. Linville, and Paul E. Anderson. Spin transistor with ultra-low energy base-collector barrier. URL https://patentimages.storage.googleapis.com/df/06/20/bb4f424060ebbc/ US7453084.pdf. U.S. Patent 7,453,084 B2, (2008).

Vlad S. Pribiag, Arjan J. A. Beukman, Fanming Qu, Maja C. Cassidy, Christophe Charpentier, Werner Wegscheider, and Leo P. Kouwenhoven. Edge-mode superconductivity in a two-dimensional topological insulator. Nature Nanotechnology, 10(7):593-597, 2015. doi:10.1038/nnano.2015.86. URL https://doi.org/10.1038/nnano.2015.86.

Hechen Ren, Falko Pientka, Sean Hart, Andrew T. Pierce, Michael Kosowsky, Lukas Lunczer, Raimund Schlereth, Benedikt Scharf, Ewelina M. Hankiewicz, Laurens W. Molenkamp, Bertrand I. Halperin, and Amir Yacoby. Topological superconductivity in a phase-controlled Josephson junction. Nature, 569(7754):93-98, 2019. doi: 10.1038/s41586-019-1148-9. URL https://doi.org/10.1038/s41586-019-1148-9.

Rie Sato and Koichi Mizushima. Spin valve transistor. URL https://patentimages. storage.googleapis.com/aa/3d/50/0de7d2784d3cc4/US6833598.pdf. U.S. Patent 2003/0122208 A1, (2003).

Adel S. Sedra and Kenneth C. Smith. Microelectronic Circuits. Oxford University Press, fifth edition, 2004.

Jairo Sinova, Sergio O. Valenzuela, J. Wunderlich, C. H. Back, and T. Jungwirth. Spin Hall effects. Rev. Mod. Phys., 87:1213-1260, Oct 2015. doi:10.1103/RevModPhys.87.1213. URL https://link.aps.org/doi/10.1103/ RevMod-Phys.87.1213.

Yaroslav Tserkovnyak, Arne Brataas, and Gerrit E. W. Bauer. Enhanced Gilbert Damping in Thin Ferromagnetic Films. Phys. Rev. Lett., 88:117601, Feb 2002. doi:10.1103/PhysRevLett.88.117601. URL https://link.aps.org/doi/10.1103/ PhysRevLett.88.117601.

Yaroslav Tserkovnyak, Arne Brataas, Gerrit E. W. Bauer, and Bertrand I. Halperin. Nonlocal magnetization dynamics in ferromagnetic heterostructures. Rev. Mod. Phys., 77:1375-1421, Dec 2005. doi:10.1103/RevMod-Phys.77.1375. URL https://link. aps.org/doi/10.1103/RevModPhys.77.1375.

S. Vaitiekėnas, Y. Liu, P. Krogstrup, and C. M. Marcus. Zero-field Topological Superconductivity in Ferromagnetic Hybrid Nanowires.

J. Weis and K. von Klitzing. Metrology and microscopic picture of the integer quantum Hall effect. Phil. Trans. R. Soc. A, 369:3954, 2011. doi: http://doi.org/10.1098/rsta.2011.0198.

Jörg Wunderlich, Byong-Guk Park, Andrew C. Irvine, Liviu P. Zârbo, Eva Rozkotová, Petr Nemec, Vít Novák, Jairo Sinova, and Tomás Jungwirth. Spin Hall Effect Transistor. Science, 330(6012):1801-1804, 2010. ISSN 0036-8075. doi: 10.1126/science.1195816. URL https://science.sciencemag.org/content/330/ 6012/1801.

## Claims

1.  An insulator based field effect topological transistor structure (TCSHTS) comprising: a topological insulator layer (4) forming a substrate with a drain area (2) and a source area (3), a gate dielectric layer (1), a gate contact separated from the substrate by the gate dielectric layer (1), a drain contact arranged next to the drain area (2) and a source contact arranged next to the source area (3), wherein

    the topological insulator layer (4) is a quantum spin Hall insulator layer,
    the drain contact is connected to the quantum spin Hall insulator layer,
    **characterised in that**
    the insulator based field effect topological transistor structure has a ferromagnetic insulator island (5) placed in proximity of the edge of the quantum spin Hall insulator layer, and
    the insulator based field effect topological transistor structure has a grounded superconducting contact (6) placed in proximity of the edge of the quantum spin Hall insulator layer and adjacent to the said ferromagnetic insulator layer.

2. Topological transistor structure (TCSHTS) according to claim 1, **characterized in that** the quantum spin Hall insulator layer comprises a two-dimensional quantum spin Hall insulator material.

3. Topological transistor structure (TCSHTS) according to claim 1, **characterized in that** the quantum spin Hall insulator layer is a quantum well structure.

4. Topological transistor structure (TCSHTS) according to claim 3, **characterized in that** the quantum well structure comprises a material selected from a group including InAs/GaSb or HgTe.

5. Topological transistor structure (TCSHTS) according to claim 4, **characterized in that** it has gate contacts provided on the top and the bottom while the drain contact and the source contact are provided on the sides.

**Patentansprüche**

1. Isolator-basierte topologische Feldeffekttransistorstruktur (TCSHTS), umfassend: eine topologische Isolatorschicht (4), die ein Substrat mit einem Drainbereich (2) und einem Sourcebereich (3) bildet, eine dielektrische Gateschicht (1), einen Gatekontakt, der durch die dielektrische Gateschicht (1) von dem Substrat getrennt ist, einen Drainkontakt, der neben dem Drainbereich (2) angeordnet ist, und einen Sourcekontakt, der neben dem Sourcebereich (3) angeordnet ist, wobei

die topologische Isolatorschicht (4) eine Quanten-Spin-Hall-Isolatorschicht ist,
der Drainkontakt mit der Quanten-Spin-Hall-Isolatorschicht verbunden ist,
**dadurch gekennzeichnet, dass**
die Isolator-basierte topologische Feldeffekttransistorstruktur eine ferromagnetische Isolatorinsel (5) aufweist, die in der Nähe des Randes der Quanten-Spin-Hall-Isolatorschicht platziert ist,
wobei die Isolator-basierte topologische Feldeffekttransistorstruktur einen geerdeten supraleitenden Kontakt (6) aufweist, der in der Nähe des Randes der Quanten-Spin-Hall-Isolatorschicht und angrenzend an die ferromagnetische Isolatorschicht platziert ist.

2. Topologische Transistorstruktur (TCSHTS) nach Anspruch 1, **dadurch gekennzeichnet, dass** die Quanten-Spin-Hall-Isolatorschicht zweidimensionales Quanten-Spin-Hall-Isolatormaterial umfasst.

3. Topologische Transistorstruktur (TCSHTS) nach Anspruch 1, **dadurch gekennzeichnet, dass** die Quanten-Spin-Hall-Isolatorschicht eine Quantentopfstruktur ist.

4. Topologische Transistorstruktur (TCSHTS) nach Anspruch 3, **dadurch gekennzeichnet, dass** die Quantentopfstruktur ein Material umfasst, das aus einer Gruppe ausgewählt ist, die InAs/GaSb oder HgTe umfasst.

5. Topologische Transistorstruktur (TCSHTS) nach Anspruch 4, **dadurch gekennzeichnet, dass** sie Gatekontakte aufweist, die an der Ober- und Unterseite vorgesehen sind, während der Drainkontakt und der Sourcekontakt an den Seiten vorgesehen sind.

**Revendications**

1. Structure de transistor topologique à effet de champ basée sur isolant (TCSHTS), comprenant: une couche isolante topologique (4) qui forme un substrat avec une zone de drain (2) et une zone de source (3), une couche diélectrique de grille (1), un contact de grille qui est séparé du substrat par la couche diélectrique de grille (1), un contact de drain qui est agencé en contiguïté avec la zone de drain (2) et un contact de source qui est agencé en contiguïté avec la zone de source (3), dans laquelle :

la couche isolante topologique (4) est une couche isolante à effet Hall et à spin quantique,
le contact de drain est connecté à la couche isolante à effet Hall et à spin quantique,
**caractérisée en ce que:**
la structure de transistor topologique à effet de champ basée sur isolant comporte un îlot isolant ferromagnétique (5) qui est positionné à proximité du bord de la couche isolante à effet Hall et à spin quantique ; et
la structure de transistor topologique à effet de champ basée sur isolant comporte un contact de supraconduction relié à une masse (6) qui est positionné à proximité du bord de la couche isolante à effet Hall et à spin quantique et qui est adjacent à ladite couche isolante ferromagnétique.

2. Structure de transistor topologique (TCSHTS) selon la revendication 1, **caractérisée en ce que** la couche isolante à effet Hall et à spin quantique comprend un matériau isolant à effet Hall et à spin quantique bidimensionnel.

3. Structure de transistor topologique (TCSHTS) selon la revendication 1, **caractérisée en ce que** la couche isolante à effet Hall et à spin quantique est une structure de puits quantique.

4. Structure de transistor topologique (TCSHTS) selon la revendication 3, **caractérisée en ce que** la structure de puits quantique comprend un matériau sélectionné parmi un groupe incluant InAs/GaSb et HgTe.

5. Structure de transistor topologique (TCSHTS) selon la revendication 4, **caractérisée en ce qu'**elle comporte des contacts de grille qui sont prévus sur le sommet et sur le fond tandis que le contact de drain et le contact de source sont prévus sur les côtés.

FIG. 1.

FIG. 2.

FIG. 3.

FIG. 4.

TCSHTS     4     5     6     Ground

Drain voltage

Contact

Drain
contact

Ferromagnetic
insulator

Superconductor

2

Quantum spin Hall insulator

3

Dielectric layer

Gate
contact 1

Gate
contact 2

Gate
contact 3

1

Gate voltage 1     Gate voltage 2     Gate voltage 3

FIG. 5.

TCSHTS

4

Quantum spin Hall insulator

Ferromagnetic
insulator

Superconductor

Drain
contact

Contact

Drain voltage

Ground

5     6

FIG. 6.

FIG. 7.

FIG. 8.

FIG. 9.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20120273763 A1
- US 20170018625 A1
- US 20030122208 A1
- US 7453084 B2

**Non-patent literature cited in the description**

- **ADEL S. SEDRA** ; **KENNETH C. SMITH.** Microelectronic Circuits.. Oxford University Press, 2004
- **ATSUFUMI HIROHATA** ; **KEISUKE YAMADA** ; **YOSHINOBU NAKATANI** ; **IOAN-LUCIAN PREJBEANU** ; **BERNARD DIÉNY** ; **PHILIPP PIRRO** ; **BURKARD HILLEBRANDS**. Review on spintronics: Principles and device applications.. *Journal of Magnetism and Magnetic Materials*, 2020, vol. 509, ISSN 0304-8853, 166711, http://www.sciencedirect.com/science/article/pii/S0304885320302353
- **ALBERT FERT.** Nobel lecture: Origin, development, and future of spintronics.. *Rev. Mod. Phys.*, December 2008, vol. 80, 1517-1530, https://link.aps.org/doi/10.1103/RevModPhys.80.1517
- **PETER A. GRÜNBERG.** Nobel lecture: From spin waves to giant magnetoresistance and beyond. *Rev. Mod. Phys.*, December 2008, vol. 80, 1531-1540, https://link.aps.org/doi/10.1103/RevModPhys.80.1531
- **J. WEIS** ; **K. VON KLITZING.** Metrology and microscopic picture of the integer quantum Hall effect.. *Phil. Trans. R. Soc. A*, 2011, vol. 369, 3954
- **CLARK A. HAMILTON.** Josephson voltage standards. *Review of Scientific Instruments*, 2000, vol. 71 (10), 3611-3623, https://aip.scitation.org/doi/abs/10.1063/1.1289507
- **LIANG FU** ; **C. L. KANE.** Superconducting Proximity Effect and Majorana Fermions at the Surface of a Topological Insulator.. *Phys. Rev. Lett.*, March 2008, vol. 100, 096407, https://link.aps.org/doi/10.1103/PhysRevLett.100.096407
- **LIANG FU** ; **CHARLES L KANE.** Josephson current and noise at a superconductor/quantum-spin-Hall-insulator/superconductor junction.. *Physical Review B*, 2009, vol. 79 (16), 161408
- **SEAN HART** ; **HECHEN REN** ; **TIMO WAGNER** ; **PHILIPP LEUBNER** ; **MATHIAS MÜHLBAUER** ; **CHRISTOPH BRÜNE** ; **HARTMUT BUHMANN** ; **LAURENS W. MOLENKAMP** ; **AMIR YACOBY.** Induced superconductivity in the quantum spin Hall edge.. *Nature Physics*, 2014, vol. 10 (9), 638-643, https://doi.org/10.1038/ nphys3036
- **VLAD S. PRIBIAG** ; **ARJAN J. A. BEUKMAN** ; **FANMING QU** ; **MAJA C. CASSIDY** ; **CHRISTOPHE CHARPENTIER** ; **WERNER WEGSCHEIDER** ; **LEO P. KOUWENHOVEN.** Edge-mode superconductivity in a two-dimensional topological insulator.. *Nature Nanotechnology*, 2015, vol. 10 (7), 593-597, https://doi.org/10. 1038/nnano.2015.86
- **HECHEN REN** ; **FALKO PIENTKA** ; **SEAN HART** ; **ANDREW T. PIERCE** ; **MICHAEL KOSOWSKY** ; **LUKAS LUNCZER** ; **RAIMUND SCHLERETH** ; **BENEDIKT SCHARF** ; **EWELINA M. HANKIEWICZ** ; **LAURENS W. MOLENKAMP**. Topological superconductivity in a phase-controlled Josephson junction. *Nature*, 2019, vol. 569 (7754), 93-98, https://doi.org/10.1038/ s41586-019-1148-9
- **ANTONIO FORNIERI** ; **ALEXANDER M. WHITICAR** ; **F. SETIAWAN** ; **ELÍAS PORTOLÉS** ; **ASBJØRN C. C. DRACHMANN** ; **ANNA KESELMAN** ; **SERGEI GRONIN** ; **CANDICE THOMAS** ; **TIAN WANG** ; **RAY KALLAHER**. Evidence of topological superconductivity in planar Josephson junctions. *Nature*, 2019, vol. 569 (7754), 89-92, https://doi.org/10.1038/ s41586-019-1068-8
- **YU LIU** ; **SAULIUS VAITIEKĖNAS** ; **SARA MARTÍ-SÁNCHEZ** ; **CHRISTIAN KOCH** ; **SEAN HART** ; **ZHENG CUI** ; **THOMAS KANNE** ; **SABBIR A. KHAN** ; **RAWA TANTA** ; **SHIVENDRA UPADHYAY**. Semiconductor-ferromagnetic insulator-superconductor nanowires: Stray field and exchange field.. *Nano Letters*, January 2020, vol. 20 (1), 456-462, https://doi.org/10.1021/acs. nanolett.9b04187

- R. M. LUTCHYN ; E. P. A. M. BAKKERS ; L. P. KOUWENHOVEN ; P. KROGSTRUP ; C. M. MARCUS ; Y. OREG. Majorana zero modes in superconductor-semiconductor heterostructures.. *Nature Reviews Materials*, 2018, vol. 3, 52, https://doi.org/10.1038/s41578-018-0003-1
- YAROSLAV TSERKOVNYAK ; ARNE BRATAAS ; GERRIT E. W. BAUER. Enhanced Gilbert Damping in Thin Ferromagnetic Films.. *Phys. Rev. Lett.*, February 2002, vol. 88, 117601, https: //link.aps.org/ doi/10.1103/PhysRevLett.88.117601
- ARNE BRATAAS ; YAROSLAV TSERKOVNYAK ; GERRIT E. W. BAUER ; BERTRAND I. HALPERIN. Spin battery operated by ferromagnetic resonance. *Phys. Rev. B*, August 2002, vol. 66, 060404, https://link. aps.org/doi/10.1103/PhysRevB.66.060404
- YAROSLAV TSERKOVNYAK ; ARNE BRATAAS ; GERRIT E. W. BAUER ; BERTRAND I. HALPERIN. Nonlocal magnetization dynamics in ferromagnetic heterostructures.. *Rev. Mod. Phys.*, December 2005, vol. 77, 1375-1421, https://link.aps.org/doi/10.1103/RevModPhys.77.1375
- JAIRO SINOVA ; SERGIO O. VALENZUELA ; J. WUNDERLICH ; C. H. BACK ; T. JUNGWIRTH. Spin Hall effects.. *Rev. Mod. Phys.*, October 2015, vol. 87, 1213-1260, https://link.aps.org/doi/10.1103/ RevModPhys.87.1213
- R. HÜTZEN ; A. ZAZUNOV ; B. BRAUNECKER ; A. LEVY YEYATI ; R. EGGER. Majorana Single-Charge Transistor.. *Phys. Rev. Lett.*, October 2012, vol. 109, 166403, https://link.aps.org/doi/10.1103/PhysRevLett.109.166403
- M. A. KASTNER. The single-electron transistor.. *Rev. Mod. Phys.*, July 1992, vol. 64, 849-858, https://link. aps.org/doi/10.1103/RevModPhys.64.849.
- JÖRG WUNDERLICH ; BYONG-GUK PARK ; ANDREW C. IRVINE ; LIVIU P. ZÂRBO ; EVA ROZKOTOVÁ ; PETR NEMEC ; VÍT NOVÁK ; JAIRO SINOVA ; TOMÁS JUNGWIRTH. Spin Hall Effect Transistor.. *Science*, 2010, vol. 330 (6012), ISSN 0036-8075, 1801-1804, https://science. sciencemag.org/content/330/6012/1801
- S. DATTA ; B. DAS. *Appl. Phys. Lett*, 1990, vol. 56, 665
- YAROSLAV TSERKOVNYAK ; ARNE BRATAAS ; GERRIT E. W. BAUER. Enhanced Gilbert Damping in Thin Ferromagnetic Films.. *Phys. Rev. Lett.*, February 2002, vol. 88, 117601, https://link.aps.org/doi/10.1103/PhysRevLett.88.117601
- ARNE BRATAAS ; YAROSLAV TSERKOVNYAK ; GERRIT E. W. BAUER ; BERTRAND I. HALPERIN. Spin battery operated by ferromagnetic resonance.. *Phys. Rev. B*, August 2002, vol. 66, 060404, https://link.aps.org/doi/10.1103/PhysRevB. 66.060404
- YAROSLAV TSERKOVNYAK ; ARNE BRATAAS ; GERRIT E. W. BAUER ; BERTRAND I. HALPERIN. Nonlocal magnetization dynamics in ferromagnetic heterostructures. *Rev. Mod. Phys.*, December 2005, vol. 77, 1375-1421, https://link.aps.org/doi/10.1103/RevModPhys.77.1375
- JAIRO SINOVA ; SERGIO O. VALENZUELA ; J. WUNDERLICH ; C. H. BACK ; T. JUNGWIRTH. Spin Hall effects.. *Rev. Mod. Phys.*, October 2015, vol. 87, 1213-1260, https://link.aps.org/doi/10.1103/RevModPhys. 87.1213
- JUNWEI LIU ; TIMOTHY H. HSIEH ; PENG WEI ; WENHUI DUAN ; JAGADEESH MOODERA ; LIANG FU. Spin-filtered edge states with an electrically tunable gap in a two-dimensional topological crystalline insulator. *Nature Materials*, 2014, vol. 13 (2), 178-183, https://doi.org/10.1038/nmat3828
- YAROSLAV TSERKOVNYAK ; ARNE BRATAAS ; GERRIT E. W. BAUER. Enhanced Gilbert Damping in Thin Ferromagnetic Films. *Phys. Rev. Lett.*, February 2002, vol. 88, 117601, https://link.aps.org/doi/10. 1103/PhysRevLett.88.117601
- ARNE BRATAAS ; YAROSLAV TSERKOVNYAK ; GERRIT E. W. BAUER ; BERTRAND I. HALPERIN. Spin battery operated by ferromagnetic resonance.. *Phys. Rev. B*, August 2002, vol. 66, 060404, https://link.aps.org/doi/10.1103/PhysRevB.66.060404
- YAROSLAV TSERKOVNYAK ; ARNE BRATAAS ; GERRIT E. W. BAUER ; BERTRAND I. HALPERIN. Nonlocal magnetization dynamics in ferromagnetic heterostructures.. *Rev. Mod. Phys.*, December 2005, vol. 77, 1375-1421, https://link.aps.org/doi/10.1103/RevModPhys.77.1375
- JAIRO SINOVA ; SERGIO O. VALENZUELA ; J. WUNDERLICH ; C. H. BACK ; T. JUNGWIRTH. Spin Hall effects.. *Rev. Mod. Phys.*, October 2015, vol. 87, 1213-1260, https://link.aps.org/doi/10.1103/RevModPhys.87.1213
- CHRISTOPH W GROTH ; MICHAEL WIMMER ; ANTON R AKHMEROV ; XAVIER WAINTAL. Kwant: a software package for quantum transport.. *New Journal of Physics*, June 2014, vol. 16 (6), 063065
- J. WEIS ; K. VON KLITZING. Metrology and microscopic picture of the integer quantum Hall effect.. *Phil. Trans. R. Soc. A,*, 2011, vol. 369, 3954, http://doi.org/10.1098/rsta.2011.0198
- RIE SATO ; KOICHI MIZUSHIMA. *Spin valve transistor*, https://patentimages. storage.googleapis.com/aa/3d/50/0de7d2784d3cc4/US6833598. pdf

- **JANUSZ J. NOWAK** ; **BRIAN W. KARR** ; **DAVID H. OLSON** ; **ERIC S. LINVILLE** ; **PAUL E. ANDERSON.** *Spin transistor with ultra-low energy base-collector barrier.*, https: //patentimages.storage.googleapis. com/df/06/20/bb4f424060ebbc/US7453084. pdf.
- **ABISHEK BANERJEE et al.** Signatures of Topological Superconductivity in Bulk Insulating Topological Insulator BiSbTe1.25Se1.75 in Proximity with Superconducting NbSe2.. *arXiv:1911.07208v1 [cond-mat.mes-hall*, 2019
- **ARNE BRATAAS** ; **YAROSLAV TSERKOVNYAK** ; **GERRIT E. W. BAUER** ; **BERTRAND I. HALPERIN.** Spin battery operated by ferromagnetic resonance.. *Phys. Rev. B*, August 2002, vol. 66, 060404, https://link.aps.org/doi/10. 1103/PhysRevB.66.060404
- **ALBERT FERT.** Nobel lecture: Origin, development, and future of spintronics.. *Rev. Mod. Phys.*, December 2008, vol. 80, 1517-1530, https: //link.aps. org/doi/10.1103/RevModPhys.80.1517
- **ANTONIO FORNIERI** ; **ALEXANDER M. WHITICAR** ; **F. SETIAWAN** ; **ELIAS PORTOLÉS** ; **ASBJØRN C. C** ; **DRACHMANN** ; **ANNA KESELMAN** ; **SERGEI GRONIN** ; **CANDICE THOMAS** ; **TIAN WANG**. Evidence of topological superconductivity in planar Josephson junctions.. *Nature*, 2019, vol. 569 (7754), 89-92, https://doi. org/10.1038/s41586-019-1068-8.
- **LIANG FU** ; **C. L. KANE.** Superconducting Proximity Effect and Majorana Fermions at the Surface of a Topological Insulator.. *Phys. Rev. Lett.*, March 2008, vol. 100, 096407, https://link.aps.org/doi/10.1103/ PhysRevLett.100.096407
- **LIANG FU** ; **CHARLES L KANE.** Josephson current and noise at a superconductor/quantum-spin-Hall-insulator/superconductor junction. *Physical Review B*, 2009, vol. 79 (16), 161408
- **CLARK A. HAMILTON.** Josephson voltage standards.. *Review of Scientific Instruments*, 2000, vol. 71 (10), 3611-3623, https://aip.scitation.org/ doi/abs/10.1063/1.1289507
- **SEAN HART** ; **HECHEN REN** ; **TIMO WAGNER** ; **PHILIPP LEUBNER** ; **MATHIAS MÜHLBAUER** ; **CHRISTOPH BRÜNE** ; **HARTMUT BUHMANN** ; **LAURENS W. MOLENKAMP** ; **AMIR YACOBY.** Induced superconductivity in the quantum spin Hall edge. *Nature Physics*, 2014, vol. 10 (9), 638-643, https://doi.org/10.1038/nphys3036.
- **ATSUFUMI HIROHATA** ; **KEISUKE YAMADA** ; **YOSHINOBU NAKATANI** ; **IOAN-LUCIAN PREJBEANU** ; **BERNARD DIÉNY** ; **PHILIPP PIRRO** ; **BURKARD HILLEBRANDS.** Review on spintronics: Principles and device applications.. *Journal of Magnetism and Magnetic Materials*, 2020, vol. 509, ISSN 0304-8853, 166711, https://doi.org/10.1016/j. jmmm.2020.166711. URL http://www.sciencedirect. com/science/article/pii/S0304885320302353
- **R. HÜTZEN** ; **A. ZAZUNOV** ; **B. BRAUNECKER** ; **A. LEVY YEYATI** ; **R. EGGER.** Majorana Single-Charge Transistor.. *Phys. Rev. Lett.*, October 2012, vol. 109, 166403, https://link.aps.org/doi/10.1103/ PhysRevLett.109.166403
- **M. A. KASTNER.** The single-electron transistor.. *Rev. Mod. Phys.*, July 1992, vol. 64, 849-858, https://link.aps.org/doi/10. 1103/RevModPhys.64.849.
- **LIN LI.** Topological Insulator-Superconductor Heterostructures and Devices.. Doctoral Thesis, 2019
- **QI I. YANG et al.** Two-Stage Proximity-Induced Gap-Opening in Topological Insulator-Insulating Ferromagnet (BixSb1-x)2Te3-EuS Bilayers. *arXiv:1804.02061v1 [cond-mat.mtrl-sci*, 2018
- **JUNWEI LIU** ; **TIMOTHY H. HSIEH** ; **PENG WEI** ; **WENHUI DUAN** ; **JAGADEESH MOODERA** ; **LIANG FU.** Spin-filtered edge states with an electrically tunable gap in a two-dimensional topological crystalline insulator. *Nature Materials*, 2014, vol. 13 (2), 178-183, https ://doi.org/10.1038/nmat3828.
- **R. M. LUTCHYN** ; **E. P. A. M. BAKKERS** ; **L. P. KOUWENHOVEN** ; **P. KROGSTRUP** ; **C. M. MARCUS** ; **Y. OREG.** Majorana zero modes in superconductor-semiconductor heterostructures.. *Nature Reviews Materials*, 2018, vol. 3, 52, https://doi. org/10.1038/s41578-018-0003-1.
- **JANUSZ J. NOWAK** ; **BRIAN W. KARR** ; **DAVID H. OLSON** ; **ERIC S. LINVILLE** ; **PAUL E. ANDERSON.** *Spin transistor with ultra-low energy base-collector barrier*, https://patentimages.storage.googleapis. com/df/06/20/bb4f424060ebbc/ US7453084.pdf.
- **VLAD S. PRIBIAG** ; **ARJAN J. A. BEUKMAN** ; **FANMING QU** ; **MAJA C. CASSIDY** ; **CHRISTOPHE CHARPENTIER** ; **WERNER WEGSCHEIDER** ; **LEO P. KOUWENHOVEN.** Edge-mode superconductivity in a two-dimensional topological insulator. *Nature Nanotechnology*, 2015, vol. 10 (7), 593-597, https://doi.org/10.1038/nnano.2015.86.
- **HECHEN REN** ; **FALKO PIENTKA** ; **SEAN HART** ; **ANDREW T. PIERCE** ; **MICHAEL KOSOWSKY** ; **LUKAS LUNCZER** ; **RAIMUND SCHLERETH** ; **BENEDIKT SCHARF** ; **EWELINA M. HANKIEWICZ** ; **LAURENS W. MOLENKAMP**. Topological superconductivity in a phase-controlled Josephson junction. *Nature*, 2019, vol. 569 (7754), 93-98, https://doi. org/10.1038/s41586-019-1148-9
- **RIE SATO** ; **KOICHI MIZUSHIMA.** *Spin valve transistor.*, https://patentimages. storage.googleapis.com/aa/3d/50/0de7d2784d3cc4/US6833598. pdf
- **ADEL S. SEDRA** ; **KENNETH C. SMITH**. Microelectronic Circuits.. Oxford University Press, 2004

- **YAROSLAV TSERKOVNYAK** ; **ARNE BRATAAS** ; **GERRIT E. W. BAUER.** Enhanced Gilbert Damping in Thin Ferromagnetic Films. *Phys. Rev. Lett*, February 2002, vol. 88, 117601, https://link.aps. org/doi/10.1103/ PhysRevLett.88.117601
- **YAROSLAV TSERKOVNYAK** ; **ARNE BRATAAS** ; **GERRIT E. W. BAUER** ; **BERTRAND I. HALPERIN**. Nonlocal magnetization dynamics in ferromagnetic heterostructures. *Rev. Mod. Phys.*, December 2005, vol. 77, 1375-1421, https://link. aps.org/-doi/10.1103/RevModPhys.77.1375
- **J. WEIS** ; **K. VON KLITZING.** Metrology and microscopic picture of the integer quantum Hall effect.. *Phil. Trans. R. Soc. A*, 2011, vol. 369, 3954, http://doi.org/10.1098/rsta.2011.0198
- **JÖRG WUNDERLICH** ; **BYONG-GUK PARK** ; **ANDREW C. IRVINE** ; **LIVIU P. ZÂRBO** ; **EVA ROZKOTOVÁ** ; **PETR NEMEC** ; **VÍT NOVÁK** ; **JAIRO SINOVA** ; **TOMÁS JUNGWIRTH.** Spin Hall Effect Transistor. *Science*, 2010, vol. 330 (6012), ISSN 0036-8075, 1801-1804, https://science.sciencemag. org/content/330/ 6012/1801.